# EUROPEAN PATENT SPECIFICATION

(11) **EP 2 741 324 B1**
(45) Date of publication and mention of the grant of the patent: **31.10.2018**
(21) Application number: 12196215.3
(22) Date of filing: 10.12.2012
(51) Int. Cl.: H01L 23/482, H01L 29/66, H01L 29/778, H01L 29/417, H01L 29/02

(54) **III nitride transistor with source connected heat-spreading plate and method of making the same**
III-Nitrid-Transistor mit einer mit dem Source verbundenen wärmeableitenden Platte und Verfahren zur Herstellung des Transistors
Transistor de nitrure de groupe III avec plaque de dissipation thermique connectée à la source et procédé de fabrication dudit transistor

(43) Date of publication of application: 11.06.2014
(73) Proprietor: IMEC VZW, 3001 Leuven (BE)
(72) Inventor: Lenci, Silvia, 3001 Leuven (BE); Decoutere, Stefaan, 3001 Leuven (BE)
(74) Representative: Patent Department IMEC

(56) References cited:
- EP-A2- 2 293 335
- US-A1- 2006 065 910
- US-A1- 2011 147 796
- PUNEET SRIVASTAVA ET AL: "Silicon Substrate Removal of GaN DHFETs for Enhanced (<1100 V) Breakdown Voltage", IEEE ELECTRON DEVICE LETTERS, IEEE SERVICE CENTER, NEW YORK, NY, US, vol. 31, no. 8, 1 August 2010 (2010-08-01) , pages 851-853, XP011311853, ISSN: 0741-3106

## Description

### Field of the Invention

The present invention is related to semiconductor devices comprising III-nitride layers forming a heterojunction to thereby create a high-electron mobility layer, also referred to as a '2-dimensional electron gas' or '2DEG' in one of said layers. The invention is primarily related to high power devices, such as High Electron Mobility Transistors (HEMT) produced on a silicon substrate, and wherein the III-nitride layers comprise at least a stack of a GaN and AlGaN layer.

### State of the art

GaN-on-Si power devices are affected by a parasitic conductive layer at the interface between Si and the III/Nitride stack, which increases the buffer leakage current and reduces the breakdown voltage. This detrimental conductive path can be interrupted by removing the Si substrate, globally over the entire wafer, as shown for example in "Silicon Substrate Removal of GaN DHFETs for enhanced (>1100V) Breakdown voltage", P. Srivastava et al, IEEE Electron Device Letters 31 (8), pp 851-853, 2010 or selectively at specific locations, see for example "Si trench around drain (STAD) technology of GaN-DHFETs on Si substrate for boosting power performance", P. Srivastava et al, Proc. International Electron Devices Meeting (IEDM) 2011. Si removal has been proven to increase the breakdown voltage without increasing the buffer thickness. Moreover, a significant reduction of the buffer leakage current at high temperature has been reported with this technology, as shown in the second of the previously cited references.

However, the concept of Si removal brings two main problems :
- Substrate backgating: The Si removal technique is meant to be used with floating substrate. In this case, any control on the backside voltage is lost, and undesired backside gating can reduce the on-state current and increase the on-resistance. If a Si substrate is present, it is possible to connect it to the source, but this decreases the breakdown voltage.
- Thermal dissipation: The Si substrate acts as a heat sink. The region of maximum channel temperature is below the gate, especially at the drain-facing side. Therefore, when the Si substrate is removed, heat dissipation can be an issue.

US2011/0147796 A1 discloses a transistor device comprising a III-nitride stack in which the front side is attached to a carrier substrate and the backside is provided with a metal carrier substrate for heat dissipation.

### Summary of the invention

The present invention provides a technique that combines the advantages of Si substrate removal (i.e. interruption of conductive path in the Si) with the possibility of reducing backgating phenomena. The invention also addresses the issue of thermal dissipation and self-heating. These solutions to the above-described problems are delivered by a device and method according to the appended claims.

The present invention is related to a III-nitride transistor device comprising a III-nitride stack comprising at least two layers with a heterojunction therebetween, so as to form a 2DEG layer in a channel formed in one of said two layers, and further comprising on said III-nitride stack source, gate and drain electrodes embedded in an insulation layer which is attached to a carrier substrate. In the production process of a device of the invention, the III-nitride stack and the electrodes are produced on a temporary substrate, which is completely removed after the attachment to the carrier. A transistor according to the invention comprises a source-connected heat spreading plate on the backside of the III-nitride stack, applied thereto after the removal of the temporary substrate, the source-connected heat spreading plate being connected to the source electrode. In a preferred embodiment, the device is a high power transistor comprising multiple finger-shaped source and drain electrodes extending from laterally placed source and drain pads. The backside metallization of the source pad is uniform with the source-connected heat spreading plates, the latter being preferably applied to said backside together with said metallization in a single process step. Anywhere in this description, the term 'source-connected heat spreading plate' may be replaced by 'source-connected heat spreading backgate'.

The invention is defined in claims 1 and 4 and is in particular related to a transistor device comprising:
- A III-nitride stack, comprising at least two layers with a heterojunction therebetween, so that a 2DEG layer may be formed in one of said two layers, said III-nitride stack having a front side surface and a back side surface, said surfaces being parallel to the plane of the layers of the stack,
- On the front side surface of said III-nitride stack : one or more sets of a source electrode, a gate electrode and a drain electrode, the gate electrode being located in between the source and drain electrodes,
- On said III-nitride stack and on said source, gate and drain electrodes : an insulation layer,
- Attached to said insulation layer : a carrier substrate,
- On the back side surface of said III-nitride stack, for each of said one or more sets of source, gate and drain electrodes : an electrically conductive plate that is electrically connected to the source electrode, said plate covering at least an area of said back side surface that is directly facing an area, said latter area being situated between the gate and the drain electrodes and directly adjacent to the gate electrode,
- On any areas of said back side surface of the III-nitride stack not covered by said plate(s), a backside passivation layer,
- Means for connecting said source, gate and drain electrodes to external contact terminals.

Said electrically conductive plate is covering an area of said back side surface that is directly facing an area consisting of the source electrode, the area between the source and the gate electrode, the gate electrode, and said area between the gate and the drain electrodes and directly adjacent to the gate electrode. Said electrically conductive plate is not covering the area corresponding to the drain electrode. Said plate is on and in contact with the back side surface of said III-nitride stack or said plate is on and in contact with a passivation layer which covers the totality of said back side surface, the passivation layer being on and in contact with said back side surface.

In one embodiment of a transistor device according to the invention, said source and drain electrodes are configured as adjacent finger-shaped electrodes, extending from laterally placed source and drain pads, said gate electrode being configured as a finger-shaped electrode connected to laterally placed gate pads, said source and drain pads being provided with backside metallization layers for connecting said source and drain pads to said external terminals, and wherein said electrically conductive plate is integral with said backside metallization layer for connecting the source electrode to an external terminal. A transistor according to the latter embodiment may comprise multiple adjacent sets of source, gate and drain electrodes, the source and drain electrodes being provided as interlocking finger-shaped electrodes, extending from oppositely placed source and drain pads.

The invention is equally related to a method for producing a transistor device according to the invention, comprising the steps of:
- Providing a temporary substrate,
- Depositing on said substrate a stack of III-nitride layers, comprising two layers that form a heterojunction between said two layers, so that a 2DEG layer may form in one of said two layers, said stack having a front side surface and a back side surface, said surfaces being parallel to the plane of the layers of the stack,
- In an active area of the front side surface of said stack of III-nitride layers, depositing and patterning one or more electrically conductive layers to form one or more sets of a source, drain and gate electrode on said active area, with the gate electrode located between the source and drain electrodes,
- Depositing one or a stack of insulating layers on said source, gate and drain electrodes and on the areas of the stack of III-nitride layers not covered by said electrodes,
- Permanently attaching the substrate to a carrier substrate, by attaching the surface of said (stack of) insulating layer(s) to said carrier substrate,
- Removing the temporary substrate, thus obtaining a structure having a front side formed by the carrier substrate, and a backside formed by the back side surface of the stack of III-nitride layers,
- producing a means for connecting said source, gate and drain electrodes to external terminals,
- producing an electrically conductive plate on said back side surface of the stack of III-nitride layers, said plate being electrically connected to the source electrode, said electrically conductive plate covering at least a portion of the area of said back side surface directly facing an area of said front side surface, the latter area being situated between the gate and the drain electrodes and directly adjacent to the gate electrode.

Said electrically conductive plate is covering an area of said back side surface that is directly facing an area of said front side surface, consisting of the source electrode, the area between the source and the gate electrode, the gate electrode, and said area between the gate and the drain electrodes and directly adjacent to the gate electrode, wherein said electrically conductive plate is not covering the area corresponding to the drain electrode. In the method of the invention, said plate is either in direct contact with the back side surface of said stack of III-nitride layers or the method comprises a step of depositing a backside passivation layer on and in contact with the totality of the back side surface of the stack of III-nitride layers, wherein said plate is produced on and in contact with said backside passivation layer.

According to an embodiment of the method, said source and drain electrodes are configured as adjacent finger-shaped electrodes, extending from laterally placed source and drain pads, said gate electrodes being configured as finger-shaped electrodes connected to laterally placed gate pads, wherein the step of providing a means for connecting said source, gate and drain electrodes to external terminals comprises the steps of :
- Etching vias through the backside of the stack of III-nitride layers, stopping on the source, gate and drain pads,
- depositing into said vias a metallization layer for connecting said source, gate and drain pads to said external terminals,
   wherein said backside metallization layer for contacting the source pad is furthermore deposited on at least a portion of the back side surface of the stack of III-nitride layers, to thereby form said electrically conductive plate(s).

In the method according to the latter embodiment, multiple sets of source, gate and drain electrodes may be produced, the source and drain electrodes being provided as interlocking finger-shaped electrodes, extending from oppositely placed source and drain pads.

### Brief description of the figures

Figure 1 illustrates a first embodiment according to the invention, wherein the source-connected heat spreading plate covers an area corresponding to the source and gate.
Figure 2 illustrates a second embodiment according to the invention.
Figures 3 and 4 illustrate a device not in accordance with the invention wherein the source-connected heat spreading plate covers the whole backside of an active area of the device.
Figure 5 illustrates an example of the lay-out of a device comprising multiple interlocking finger-shaped source and drain electrodes.
Figure 6 illustrates 3D-views of the source and drain metallization in a device according an embodiment of the invention.
Figure 7 is a cross-section of the source pad area in a device according to the invention.
Figure 8 illustrates further 3D-views of the source and drain structures in a device according an embodiment of the invention.

### Detailed description of the invention

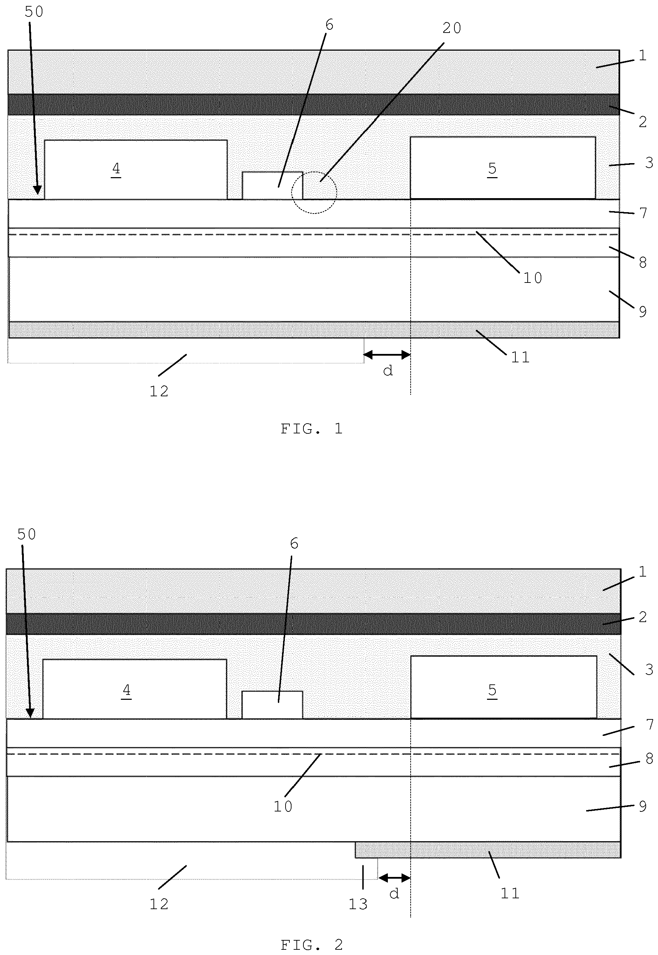

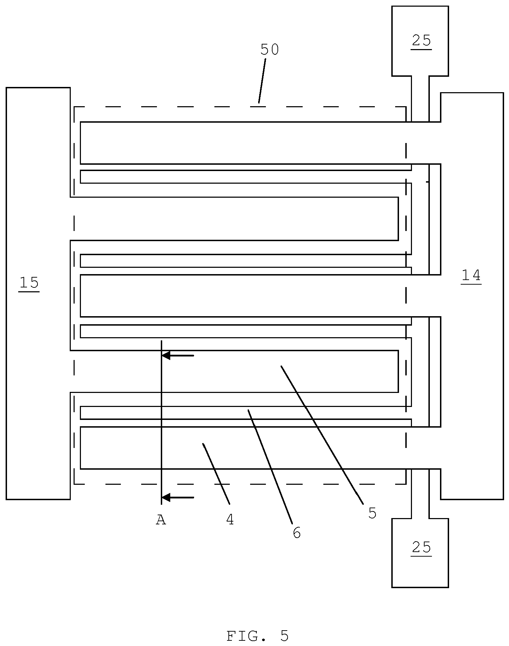

Figures 1 and 2 illustrate two possible embodiments of a transistor according to the invention. The figures may be seen as cross-sections of a single transistor or of a portion of a high power HEMT device structure with multiple interlocking source and drain fingers, connected to contact pads, as illustrated in figure 5. This structure, which is known as such, is provided with contact pads 14 for the source, 15 for the drain and 25 for the gate, while the interlocking fingers are located in the active area 50, i.e. the area in which the actual currents are taking place through the transistor's channel when the transistor is conducting. The active area is to be distinguished from for example the contact pad areas 14, 15. The views shown in figures 1 to 4 may be seen as cross-sections taken in the active area, along the line indicated as 'A' in figure 5. The invention is not limited however to a particular transistor design.

In figure 1, the following components are indicated : a carrier substrate 1, a permanent bonding layer 2, an insulation layer 3, possibly consisting of a stack of insulation layers of different material and/or composition, and electrically conductive, preferably metal source 4, gate 6 and drain 5 electrodes (hereafter referred to also as 'source', 'drain' and 'gate' for reasons of conciseness), with the gate in between the source and drain. The source, drain and gate are in contact with a III-nitride barrier layer 7, which is itself in contact with a III-nitride channel layer 8, the latter being in contact with a III-nitride buffer layer 9. The stack of layers 7 to 9 will hereafter be referred to as the III-nitride stack. When used with respect to a transistor according to the invention, the term 'III-nitride stack' refers to the portion of the stack of active layers (such as layers 7/8/9) that corresponds to the active area 50. The III-nitride stack has a front and back surface parallel to the layers of the stack. The gate 6 can be a metal gate in direct contact with the III-nitride stack. It can also be a metal gate with a gate dielectric (preferably oxide) between the metal gate and the III-nitride stack.

According to a preferred embodiment, the barrier layer 7 is an AlGaN layer, the channel layer 8 is a GaN layer and the buffer layer may for example consist of a stack of Al₁₋ₓGaₓN layers, with varying values of x. Other suitable III-nitride materials known in the art are possible also (e.g. InGaN). The barrier and channel layers 7 and 8 form a heterojunction between them, i.e. these layers differ in terms of the band gap of the respective materials of these layers, so that a 2DEG layer 10 (2-dimensional electron gas) may be formed in the channel layer 8. The 2DEG is either present permanently, or only when a suitable external voltage is applied to one or more of the source, drain and gate electrodes. This is the difference between a normally ON' and normally OFF' device. The III-nitride stack may comprise additional layers. The composition of such a stack in terms of the function of the layers and the materials and layer thicknesses that are suitable for forming a 2DEG are known as such in the art.

Also, the components described so far are obtainable by a process that is known per se in the art, and wherein subsequently the buffer layer 9, the channel layer 8, the barrier layer 7, the source, drain and gate electrodes 4-6 and at least a portion of the insulation layer 3 are produced on a substrate, preferably a silicon substrate, possibly with a nucleation layer on its surface to minimise the mismatch between the silicon and the buffer layer 9. In the production process of a transistor according to the invention (described in more detail in the claims and further in this description), the silicon substrate and the components on it are then attached to the carrier substrate 1 through the permanent bonding layer 2, by attaching the insulating layer 3 to said bonding layer. After that, the silicon substrate is removed entirely by a process known per se, preferably a process comprising one or more grinding steps combined with one or more etching steps. The carrier substrate side of the resulting device is hereafter called the device's front side, the opposite side is called the device's back side.

In the embodiment of figure 1, a backside passivation layer 11 is then deposited on the backside (i.e. on the buffer layer 9). Characteristically to the invention, an electrically conductive backside layer 12, preferably a metal layer, is then produced on the backside passivation layer 11, the backside layer 12 covering the area corresponding to the source 4 and the gate 6 and a portion of the area between the gate 6 and the drain 5. This backside layer 12 is electrically connected to the source 4, and is called 'source-connected heat spreading plate' in the context of this description. In a device of the design illustrated in figure 5, the connection to the source takes place through a metal connection from the back of the device to the front, that contacts the source pad 14 in an area outside the active area 50. This will be shown in detail for the case of a multifinger device like the one shown in figure 5. The connection to the source may however be established in any way known to the skilled person.

The source-connected heat spreading plate has a double effect:
- It connects the source 4 to the backside of the device, and thereby acts as a backside field plate, reducing the backside gating effect, whilst the advantages of the removal of the entire silicon substrate are equally obtained, namely the disappearance of a parasitic conductive layer at the interface between Si and the III-nitride stack.
- It is positioned under the region of maximum junction temperature, which is the region between the gate 6 and the drain, closest to the gate, indicated approximately by the area 20 in figure 1. Therefore it also acts as a heat sink.
Due to the double function of the source-connected heat-spreading plate 12, this plate may also be referred to as a 'source connected heat spreading backgate'.

In the embodiment of figure 1, the source-connected heat spreading plate 12 does not cover the area corresponding to the drain 5. Depending on the thickness and materials of the III-nitride stack, breakdown of the device may occur through the current path from the drain electrode 5 to the plate 12 when the transistor is in off-state and high voltage is applied to the drain. The distance d between the edge of the plate 12 and the drain 5 may be optimized in this embodiment in order to maximize or tune the voltage at which breakdown through this current path occurs.

In the embodiment of figure 2, the source-connected heat spreading plate 12 is in direct contact with the buffer layer 9. Again, the plate does not cover the area corresponding to the drain 5. The device of figure 2 may be obtained by first depositing and patterning the backside passivation layer 11, said patterning taking place to create openings in said layer 11, after which a metal layer 12 is deposited in said openings, either deposited only in said openings or deposited everywhere and subsequently patterned, which may result in the small overlap 13 shown in figure 2. This embodiment thus requires more process steps, but the direct contact between the source-connected heat spreading plate 12 and the III-nitride stack allows to optimize the heat spreading capability of the plate. Again the lateral distance d between the plate and the drain is preferably optimized to maximize or tune the breakdown voltage.

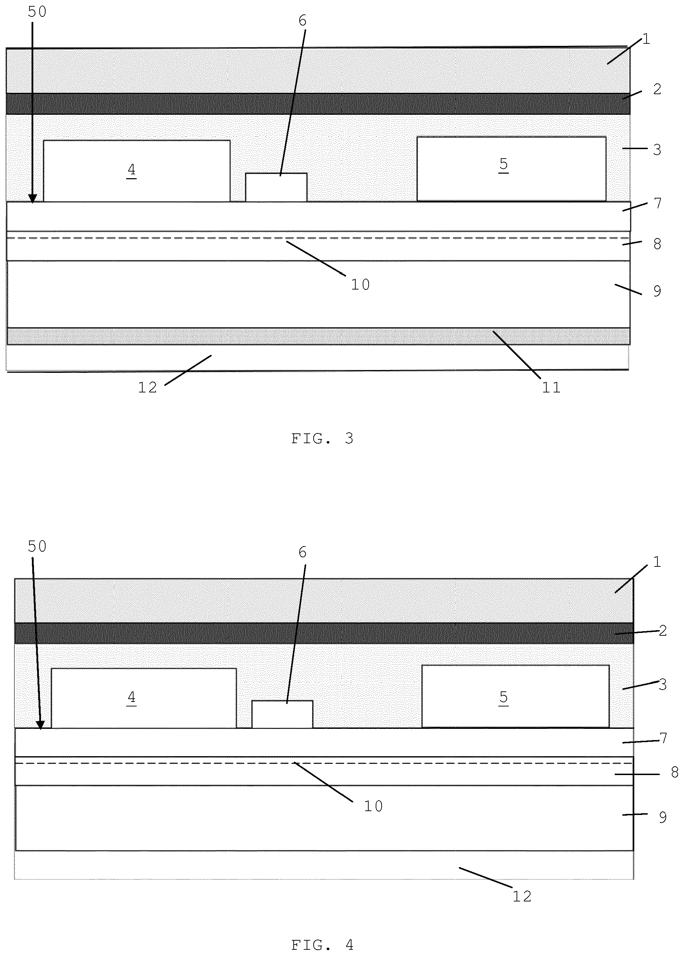

Figure 3 shows a device that is not according to the invention, according to which the source-connected heat spreading plate 12 and the backside passivation layer 11 are deposited on the totality of the backside of the III-nitride stack. This allows the production of the device in a reduced number of process steps, but it may require the application of additional layers or thicker layers in the III-nitride stack or an appropriate choice of materials of said III-nitride layers, in order to avoid breakdown of the transistor at too low voltages (in absolute value). The same is true for the device of figure 4, where the source-connected heat spreading plate 12 is present on the totality of the backside of the III-nitride stack, and directly on the surface of the buffer layer 9 (i.e. directly on the III-nitride stack), and without a backside passivation layer.

Other embodiments may include different sizes and shapes of the source-connected heat spreading plate 12. The preferred shape when the source and drain electrodes are bar-shaped, is a rectangular plate. The plate 12 must cover at least an area of the device's backside surface that is directly facing an area 20 between the gate and the drain, and directly adjacent to the gate. 'Directly facing' means that the area on the backside is the mirror image of the corresponding area on the front side, with respect to the centre plane between the back side and front side.

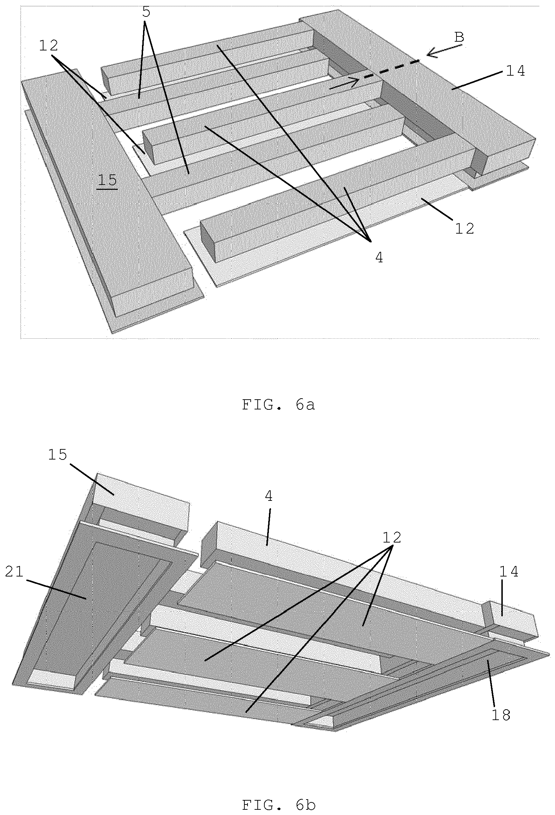

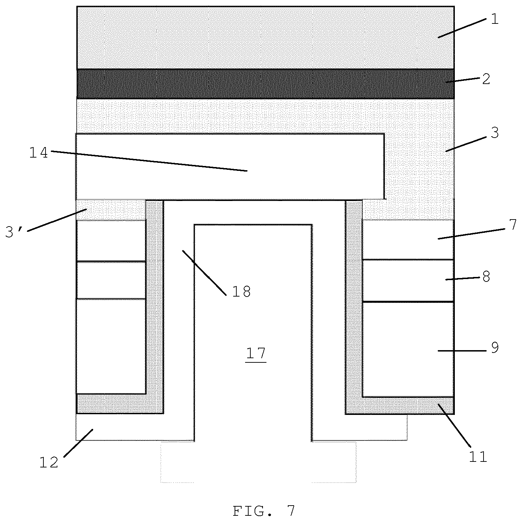

Figures 6a and 6b show 3D views of the source and drain metallization in a multifinger device like the one shown in figure 5, but adapted according to the embodiment of figure 1. The source and drain electrodes 4 and 5 in the active area are indicated. Laterally, the source and drain pads 14 and 15 are present, which are electrically connected and preferably uniform with the source and drain electrodes 4 and 5 respectively. The source-connected heat spreading plates 12 are visible underneath the source and gate electrodes, as shown also in the cross section of figure 1 (the gate electrodes are not shown in figure 6, neither are the various structural layers 1 to 3 and 7 to 11). Figure 6b shows a view from the backside, showing the backside drain metallization 21 and indicating how the source-connected heat spreading plates 12 are connected to the backside source metallization 18. This is further explained on the basis of figure 7, which shows a vertical cross-section along line B (fig. 6a) through the source pad area 14, including all the structural layers, which are also visible in the cross-sections of figures 1 to 4 : the carrier substrate 1, bonding layer 2, insulation layer 3, barrier layer 7, channel layer 8 and buffer layer 9. The source pad 14 is uniform with the source finger-shaped electrodes 4. In the source pad area, a portion 3' of the insulation layer is present between the source pad and the barrier layer. Said portion 3' does not extend underneath the active area 50.

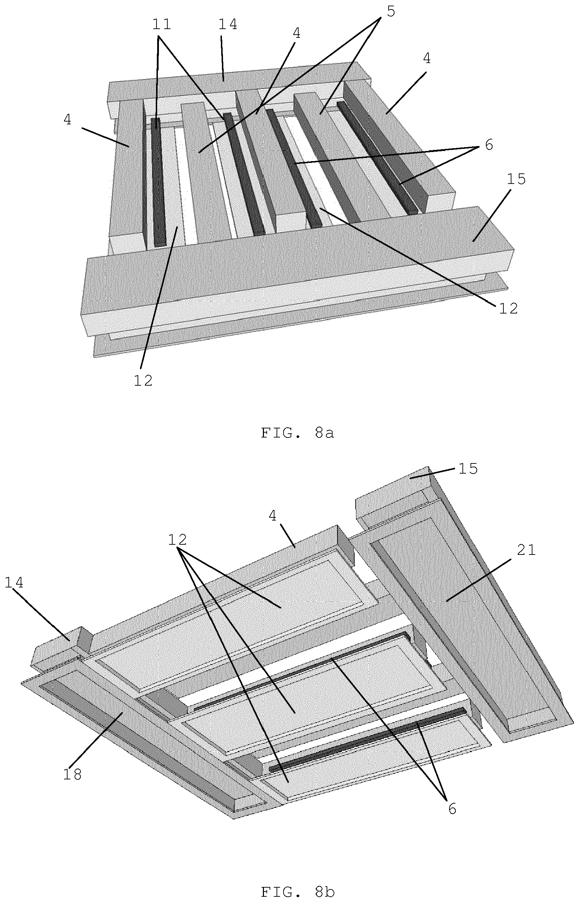

The device is contacted from the backside, by etching a via 17 and depositing a metal layer 18 into said via, the metal layer being in contact with the source pad 14. In a preferred embodiment of the invention, this metal layer extends underneath the active area and there it forms the source-connected heat spreading plate or plates 12, i.e. the source-connected heat spreading plates are uniform with the backside metallization 18. In the embodiment of figure 7, the backside passivation layer 11 is first deposited into the via 17 and on the entire backside of the device (pad areas and active area). Then the passivation layer is removed from the bottom of the via 17 by a suitable etching technique, after which the metal layer 18 is deposited on and in contact with the passivation layer 11 (except at the bottom of the via 17 where it is deposited on and in contact with the source pad 14). The metal layer 18 may then be patterned to form the source-connected heat spreading plates 12 only underneath the source and gate fingers as in figure 1. To obtain the embodiment of figure 2, where the source-connected heat spreading plates have a small overlap with the backside passivation layer, said backside passivation layer 11 is patterned in the active area before depositing the metal layer 18 and patterning the latter to form the source-connected heat spreading plates 12 underneath the source and gate fingers. This embodiment is illustrated in the 3D views of figures 8a and 8b, which do include the gate electrodes 6. To obtain the device of figure 4, no backside passivation layer is deposited on the active area. The metal layer 18 is deposited directly on the barrier layer 9. In any embodiment according to the invention involving laterally placed contact pads 14/15, a passivation layer is preferably applied in said pad areas, in the same way as described in relation to figure 7, in order to avoid shorting of the III-nitride layers.

The invention is also related to a method as disclosed in the appended claims, for producing a transistor according to the invention. Some references to method steps applicable for the production of the above described embodiments have already been mentioned in the preceding paragraphs. According to the method, the initial substrate onto which the III-nitride stack 9-8-7 (in that order), the source, gate and drain electrodes and the insulation layer 3 are produced is removed entirely, after attachment of the carrier substrate to the insulation layer 3. When used in relation to the method of the invention, the term 'III-nitride stack' may refer to a stack of layers covering a larger area than the active area 50 of a particular transistor, for example a stack of III-nitride layers deposited on a larger substrate and to be processed to form the III-nitride stacks of a number of transistors produced on the substrate. The deposition of the III-nitride stack, the deposition and patterning of the electrodes and the deposition of the insulating layer 3 (preferably consisting of several layers) can be performed according to any suitable technique known in the art. The same is true for the attachment to the carrier substrate and the removal of the initial substrate. The deposition and (if applicable) patterning of the source-connected heat spreading plate may also be applied according to a known technique.

The material of the source-connected heat spreading plate may for example be an Al-based metal of about 1 µm thick, deposited by sputtering or evaporation. The backside passivation layer 11 may be any dielectric layer, suitable for passivating the backside of the III-nitride layer, for example a silicon oxide (SiO₂) layer or a silicon nitride layer (Si₃N₄). If applicable, the backside passivation layer 11 is deposited on the III-nitride stack's back side before deposition of the source heat spreading layer 12. If the latter is not to be present on the totality of the surface, the passivation layer is first patterned to form openings in said layer, upon which the metal layer for forming the heat spreading plates is deposited in said openings and on the remainder of the passivation layer, after which said metal layer is patterned to form the separate plates, possibly overlapping the passivation layer in an edge area 13 as in the embodiment of figure 2. In embodiments, the source-connected heat spreading plate does not cover the totality of the III-nitride stack's back side's surface portion that is directly facing the active area 50 and a passivation layer is present on every area of said backside portion of the III-nitride stack where no source heat spreading layer is present. This is required given that the initial substrate is removed entirely from said area facing the active area 50.

In the case of the multi-finger electrode device illustrated by the 2D/3D views and sections of figures 5 to 8, the source, drain and gate pads 14/15/25 are deposited and patterned together with the electrodes 4/5/6. The source-connected heat spreading plate is obtained in the same deposition step as the backside metallization 18 of the source pads, after etching vias 17 through the backside of the III-nitride stack, stopping on the source pad 14. In the embodiment of figure 7, the backside passivation layer 11 is deposited conformally after formation of the vias 17, so that it lines the sides and bottom of the vias, after which said backside passivation layer is removed from the bottom. In this way, the sides of the vias remain covered by the passivation material, thereby avoiding shorting of the layers of the III-nitride stack. The metallization 18 is then deposited after said removal of the passivation from the bottom of the vias. Even when no backside passivation layer is to be deposited on the backside of the III-nitride stack directly facing the active area 50 (as in figure 4), it is preferred to avoid shorting of the III-nitride layers in the above described way, by depositing and patterning said passivation layer only in the pad areas 14/15.

In the foregoing description a patterning step is to be understood as any procedure in which portions of a layer are removed by etching away said portions while the remainder of the layer is protected by an etch mask, leaving a pattern formed by the remaining parts of the layer. The patterning may take place by known photolithography techniques involving a resist layer, or by hard mask techniques, equally known in the art.

## Claims

1. A transistor device comprising :
- A III-nitride stack, comprising at least two layers (7,8) with a heterojunction therebetween, so that a 2DEG layer may be formed in one of said two layers, said III-nitride stack having a front side surface and a back side surface,
- On the front side surface of said III-nitride stack : a set of a source electrode (4), a gate electrode (6) and a drain electrode (5), the gate electrode being located in between the source and drain electrodes,
- On said III-nitride stack and on said source, gate and drain electrodes : an insulation layer (3),
- Attached to said insulation layer : a carrier substrate (1),
- On the back side surface of said III-nitride stack, for said set of source, gate and drain electrodes : an electrically conductive plate (12) that is electrically connected to the source electrode (4), said plate covering at least an area of said back side surface that is directly facing an area (20), said latter area (20) being situated between the gate and the drain electrodes and directly adjacent to the gate electrode,
- On areas of said back side surface of the III-nitride stack not covered by said plate, a backside passivation layer (11),
- Means for connecting said source, gate and drain electrodes (4,6,5) to external contact terminals,
wherein said electrically conductive plate (12) is covering an area of said back side surface that is directly facing an area consisting of the source electrode (4), the area between the source and the gate electrodes (6), the gate electrode (6), and said area (20) between the gate and the drain electrodes and directly adjacent to the gate electrode, and wherein said electrically conductive plate (12) is not covering the area corresponding to the drain electrode (5), and wherein said plate (12) is on and in contact with the back side surface of said III-nitride stack or wherein said plate (12) is on and in contact with a passivation layer (11) which covers the totality of said back side surface, the passivation layer being on and in contact with said back side surface.

2. Transistor device according to claim 1, wherein said source and drain electrodes (4,6) are configured as adjacent finger-shaped electrodes, extending from laterally placed source and drain pads (14,15), said gate electrode (6) being configured as a finger-shaped electrode connected to laterally placed gate pads (25), said source and drain pads being provided with backside metallization layers (18,21) for connecting said source and drain pads to said external contact terminals, wherein said electrically conductive plate (12) is integral with said backside metallization layer (18) for connecting the source electrode (4) to the respective external contact terminal.

3. Transistor device according to claim 2, comprising multiple adjacent sets of source, gate and drain electrodes (4,6,5), the source and drain electrodes being provided as interlocking finger-shaped electrodes, extending from oppositely placed source and drain pads (14,15).

4. Method for producing a transistor device according to any one of claims 1 to 3, comprising the steps of :
• Providing a temporary substrate,
• Depositing on said substrate a stack of III-nitride layers, comprising two layers (7,8) that form a heterojunction between said two layers, so that a 2DEG layer may form in one of said two layers, said stack having a front side surface and a back side surface,
• In an active area (50) of the front side surface of said stack of III-nitride layers, depositing and patterning one or more electrically conductive layers to form a set of a source, drain and gate electrode (4,5,6) on said active area, with the gate electrode located between the source and drain electrodes,
• Depositing one or a stack of insulating layers (3) on said source, gate and drain electrodes and on the areas of the stack of III-nitride layers not covered by said electrodes,
• Permanently attaching the substrate to a carrier substrate (1), by attaching the surface of said (stack of) insulating layer(s) (3) to said carrier substrate (1),
• Removing the temporary substrate, thus obtaining a structure having a front side formed by the carrier substrate (1), and a backside formed by the back side surface of the stack of III-nitride layers,
• producing a means for connecting said source, gate and drain electrodes (4,6,5) to external terminals,
• producing an electrically conductive plate (12) on said back side surface of the stack of III-nitride layers, said plate being electrically connected to the source electrode (4), said electrically conductive plate covering at least a portion of the area of said back side surface directly facing an area (20) of said front side surface, the latter area (20) being situated between the gate and the drain electrodes and directly adjacent to the gate electrode
wherein said electrically conductive plate (12) is covering an area of said back side surface that is directly facing an area of said front side surface, consisting of the source electrode (4), the area between the source and the gate electrodes (6), the gate electrode (6), and said area (20) between the gate and the drain electrodes and directly adjacent to the gate electrode, and wherein said electrically conductive plate (12) is not covering the area corresponding to the drain electrode (5),
and wherein said plate (12) is in direct contact with the back side surface of said stack of III-nitride layers or wherein the method comprises a step of depositing a backside passivation layer (11) on and in contact with the totality of the back side surface of the stack of III-nitride layers and wherein said plate (12) is produced on and in contact with said backside passivation layer (11).

5. Method according to claim 4, wherein said source and drain electrodes (4, 6) are configured as adjacent finger-shaped electrodes, extending from laterally placed source and drain pads (14,15), said gate electrode being configured as a finger-shaped electrode connected to laterally placed gate pads (25), and wherein the step of providing a means for connecting said source, gate and drain electrodes to external terminals comprises the steps of :
• Etching vias (17) through the backside of the stack of III-nitride layers, stopping on the source, gate and drain pads,
• depositing into said vias a metallization layer for connecting said source, gate and drain pads to said external terminals,
wherein a backside metallization layer (18) for contacting the source pad (14) is furthermore deposited on at least a portion of the back side surface of the stack of III-nitride layers, to thereby form said electrically conductive plate.

6. Method according to claim 5, wherein multiple sets of source, gate and drain electrodes (4,6,5) are produced, the source and drain electrodes being provided as interlocking finger-shaped electrodes, extending from oppositely placed source and drain pads (14,15).

## Patentansprüche

1. Transistorvorrichtung umfassend :
- einen III-Nitrid-Stapel, umfassend mindestens zwei Schichten (7, 8) mit einem Heteroübergang dazwischen, so dass eine 2DEG-Schicht in einer der beiden Schichten gebildet werden kann, wobei der III-Nitrid-Stapel eine vorderseitige Oberfläche und eine rückseitige Oberfläche aufweist,
- auf der vorderseitigen Oberfläche des III-Nitrid-Stapels: einen Satz einer Source-Elektrode (4), einer Gate-Elektrode (6) und einer Drain-Elektrode (5), wobei sich die Gate-Elektrode zwischen der Source- und der Drain-Elektrode befindet,
- auf dem III-Nitrid-Stapel und auf den Source-, Gate- und Drain-Elektroden: eine Isolierschicht (3),
- an die Isolationsschicht befestigt: ein Trägersubstrat (1),
- auf der rückseitigen Oberfläche des III-Nitrid-Stapels für den Satz von Source-, Gate- und Drain-Elektroden: eine elektrisch leitende Platte (12), die mit der Source-Elektrode (4) elektrisch verbunden ist, wobei die Platte mindestens einen Bereich der rückseitigen Oberfläche bedeckt, der direkt einem Bereich (20) zugewandt ist, wobei der letztgenannte Bereich (20) zwischen der Gate- und der Drain-Elektrode und direkt an die Gate-Elektrode angrenzend angeordnet ist,
- auf Bereichen der rückseitigen Oberfläche des III-Nitrid-Stapels, die nicht von der Platte bedeckt sind, eine rückseitige Passivierungsschicht (11),
- Mittel zum Anschluss der Source-, Gate- und Drain-Elektroden (4, 6, 5) an externe Kontaktanschlüsse,
wobei die elektrisch leitende Platte (12) einen Bereich der rückseitigen Oberfläche bedeckt, der direkt einem Bereich zugewandt ist, der aus der Source-Elektrode (4), dem Bereich zwischen der Source- und der Gate-Elektrode (6), der Gate-Elektrode (6), und dem Bereich (20) zwischen der Gate- und der Drain-Elektrode und direkt an die Gate-Elektrode angrenzend besteht, und wobei die elektrisch leitende Platte (12) nicht den Bereich bedeckt, der der Drain-Elektrode (5) entspricht, und wobei die Platte (12) sich auf und in Kontakt mit der rückseitigen Oberfläche des III-Nitrid-Stapels befindet oder wobei die Platte (12) sich auf und in Kontakt mit einer Passivierungsschicht (11) befindet, die die Gesamtheit der rückseitigen Oberfläche bedeckt, wobei sich die Passivierungsschicht auf und in Kontakt mit der rückseitigen Oberfläche befindet.

2. Transistorvorrichtung nach Anspruch 1, wobei die Source- und Drain-Elektroden (4, 6) als nebeneinanderliegende fingerförmige Elektroden konfiguriert sind, die sich von seitlich platzierten Source- und Drain-Pads (14, 15) erstrecken, wobei die Gate-Elektrode (6) als fingerförmige Elektrode konfiguriert ist, die mit seitlich platzierten Gate-Pads (25) verbunden ist, wobei die Source- und Drain-Pads zum Verbinden der Source- und Drain-Pads mit den externen Kontaktanschlüssen mit rückseitigen Metallisierungsschichten (18, 21) versehen sind,
wobei die elektrisch leitende Platte (12) mit der rückseitigen Metallisierungsschicht (18) zum Verbinden der Source-Elektrode (4) mit dem jeweiligen externen Kontaktanschluss einstückig ist.

3. Transistorvorrichtung nach Anspruch 2, umfassend mehrere nebeneinanderliegende Sätze von Source-, Gate- und Drain-Elektroden (4, 6, 5), wobei die Source- und Drain-Elektroden als ineinandergreifende fingerförmige Elektroden vorgesehen sind, die sich von gegenüber platzierten Source- und Drain-Pads (14, 15) erstrecken.

4. Verfahren zum Herstellen einer Transistorvorrichtung nach einem der Ansprüche 1 bis 3, umfassend die folgenden Schritte:
- Bereitstellen eines temporären Substrats,
- Abscheiden eines Stapels von III-Nitridschichten auf dem Substrat, umfassend zwei Schichten (7, 8), die einen Heteroübergang zwischen den beiden Schichten bilden, so dass sich in einer der beiden Schichten eine 2DEG-Schicht bilden kann, wobei der Stapel eine vorderseitige Oberfläche und eine rückseitige Oberfläche aufweist,
- In einem aktiven Bereich (50) der vorderseitigen Oberfläche des Stapels von III-Nitridschichten, Abscheiden und Strukturieren einer oder mehrerer elektrisch leitender Schichten, um einen Satz einer Source-, Drain- und Gate-Elektrode (4, 5, 6) auf dem aktiven Bereich zu bilden, wobei sich die Gate-Elektrode zwischen der Source- und der Drain-Elektrode befindet,
- Abscheiden einer oder eines Stapels von Isolierschichten (3) auf die Source-, Gate- und Drain-Elektroden und auf die nicht von den Elektroden bedeckten Bereiche des Stapels von III-Nitridschichten,
- Dauerhaftes Befestigen des Substrats an einem Trägersubstrat (1) durch Befestigen der Oberfläche der (des Stapels von) Isolierschicht(en) (3) an dem Trägersubstrat (1).
- Entfernen des temporären Substrats, wodurch eine Struktur mit einer Vorderseite, die durch das Trägersubstrat (1) gebildet wird, und einer Rückseite, die durch die rückseitige Oberfläche des Stapels von III-Nitridschichten gebildet wird, erhalten wird,
- Herstellen eines Mittels zum Verbinden der Source-, Gate- und Drain-Elektroden (4, 6, 5) mit externen Anschlüssen,
- Herstellen einer elektrisch leitenden Platte (12) auf der rückseitigen Oberfläche des Stapels von III-Nitridschichten, wobei die Platte elektrisch mit der Source-Elektrode (4) verbunden ist, wobei die elektrisch leitende Platte zumindest einen Teil des Bereichs der rückseitigen Oberfläche bedeckt, der direkt einem Bereich (20) der vorderseitigen Oberfläche zugewandt ist, wobei der letztere Bereich (20) zwischen der Gate und der Drain-Elektrode und direkt an die Gate-Elektrode angrenzend angeordnet ist,
wobei die elektrisch leitende Platte (12) einen Bereich der rückseitigen Oberfläche bedeckt, der direkt einem Bereich der vorderseitigen Oberfläche zugewandt ist, bestehend aus der Source-Elektrode (4), dem Bereich zwischen der Source- und der Gate-Elektrode (6), der Gate-Elektrode (6) und dem Bereich (20) zwischen der Gate- und der Drain-Elektrode und direkt angrenzend an die Gate-Elektrode, und wobei die elektrisch leitende Platte (12) den der Drain-Elektrode (5) entsprechenden Bereich nicht bedeckt,
und wobei die Platte (12) in direktem Kontakt mit der rückseitigen Oberfläche des Stapels von III-Nitridschichten steht oder wobei das Verfahren einen Schritt des Abscheidens einer rückseitigen Passivierungsschicht (11) auf und in Kontakt mit der Gesamtheit der Rückseite des Stapels von III-Nitridschichten umfasst und wobei die Platte (12) auf und in Kontakt mit der rückseitigen Passivierungsschicht (11) hergestellt wird.

5. Verfahren nach Anspruch 4, wobei die Source- und Drain-Elektroden (4, 6) als nebeneinanderliegende fingerförmige Elektroden konfiguriert sind, die sich von seitlich platzierten Source- und Drain-Pads (14, 15) erstrecken, wobei die Gate-Elektrode als eine fingerförmige Elektrode ausgebildet ist, die mit seitlich angeordneten Gate-Pads (25) verbunden sind, und wobei der Schritt des Bereitstellens eines Mittels zum Verbinden der Source-, Gate- und Drain-Elektroden mit externen Anschlüssen die folgenden Schritte umfasst:
- Ätzen von Durchkontakten (17) durch die Rückseite des Stapels von III-Nitridschichten, Stoppen auf den Source-, Gate- und Drain-Pads,
- Abscheiden einer Metallisierungsschicht zum Verbinden der Source-, Gate- und Drain-Pads mit den externen Anschlüssen in die Durchkontakte, wobei eine rückseitige Metallisierungsschicht (18) zum Kontaktieren des Source-Pads (14) weiterhin auf mindestens einem Teil der rückseitigen Oberfläche des Stapels von III-Nitridschichten abgeschieden wird, um dadurch die elektrisch leitende Platte zu bilden.

6. Verfahren nach Anspruch 5, wobei mehrere Sätze von Source-, Gate- und Drain-Elektroden (4, 6, 5) hergestellt werden, wobei die Source- und Drain-Elektroden als ineinandergreifende fingerförmige Elektroden vorgesehen sind, die sich von gegenüber platzierten Source- und Drain-Pads (14, 15) erstrecken.

## Revendications

1. Dispositif de transistor comprenant :
- un empilement de nitrure III, comprenant au moins deux couches (7, 8) avec une hétérojonction entre elles, de sorte qu'une couche 2DEG peut être formée dans l'une desdites deux couches, ledit empilement de nitrure III ayant une surface avant et une surface arrière,
- sur la surface avant dudit empilement de nitrure III : un ensemble d'une électrode source (4), d'une électrode de grille (6) et d'une électrode de drain (5), l'électrode de grille étant située entre les électrodes source et de drain,
- sur ledit empilement de nitrure III et sur lesdites électrodes source, de grille et de drain : une couche isolante (3),
- fixé à ladite couche isolante : un substrat de support (1),
- sur la surface arrière dudit empilement de nitrure III, pour ledit ensemble d'électrodes source, de grille et de drain : une plaque électriquement conductrice (12) qui est reliée électriquement à l'électrode source (4), ladite plaque recouvrant au moins une zone de ladite surface arrière qui est directement en regard d'une zone (20), ladite dernière zone (20) étant située entre les électrodes de grille et de drain et directement adjacente à l'électrode de grille,
- sur les zones de ladite surface arrière de l'empilement de nitrure III non recouvertes par ladite plaque, une couche de passivation arrière (11),
- un moyen de liaison desdites électrodes source, de grille et de drain (4, 6, 5) à des bornes de contact externes,
dans lequel ladite plaque électriquement conductrice (12) recouvre une zone de ladite surface arrière qui est directement en regard d'une zone constituée de l'électrode source (4), de la zone entre les électrodes source et de grille (6), de l'électrode de grille (6), et de ladite zone (20) entre les électrodes de grille et de drain et directement adjacente à l'électrode de grille, et dans lequel ladite plaque électriquement conductrice (12) ne recouvre pas la zone correspondant à l'électrode de drain (5), et dans lequel ladite plaque (12) est sur et en contact avec la surface arrière dudit empilement de nitrure III ou dans lequel ladite plaque (12) est sur et en contact avec une couche de passivation (11) qui recouvre la totalité de ladite surface arrière, la couche de passivation étant sur et en contact avec ladite surface arrière.

2. Dispositif de transistor selon la revendication 1, dans lequel lesdites électrodes source et de drain (4, 6) sont configurées sous la forme d'électrodes digitiformes adjacentes, s'étendant à partir de plots de source et de drain (14, 15) placés latéralement, ladite électrode de grille (6) étant configurée sous la forme d'une électrode digitiforme reliée à des plots de grille (25) placés latéralement, lesdits plots de source et de drain étant pourvus de couches de métallisation arrière (18, 21) pour relier lesdits plots de source et de drain auxdites bornes de contact externes, dans lequel ladite plaque électriquement conductrice (12) fait partie intégrante de ladite couche de métallisation arrière (18) pour relier l'électrode source (4) à la borne de contact externe respective.

3. Dispositif de transistor selon la revendication 2, comprenant de multiples ensembles adjacents d'électrodes source, de grille et de drain (4, 6, 5), les électrodes source et de drain étant fournies sous la forme d'électrodes digitiformes s'interpénétrant, s'étendant à partir de plots de source et de drain (14, 15) placés de manière opposée.

4. Procédé de production d'un dispositif de transistor selon l'une quelconque des revendications 1 à 3, comprenant les étapes de :
• fourniture d'un substrat temporaire,
• dépôt sur ledit substrat d'un empilement de couches de nitrure III, comprenant deux couches (7, 8) qui forment une hétérojonction entre lesdites deux couches, de sorte qu'une couche 2DEG peut se former dans l'une desdites deux couches, ledit empilement ayant une surface avant et une surface arrière,
• dans une zone active (50) de la surface avant dudit empilement de couches de nitrure III, le dépôt et la structuration d'une ou plusieurs couches électriquement conductrices pour former un ensemble d'une électrode source, de drain et de grille (4, 5, 6) sur ladite zone active, avec l'électrode de grille située entre les électrodes source et de drain,
• dépôt d'une ou d'un empilement de couches isolantes (3) sur lesdites électrodes source, de grille et de drain et sur les zones de l'empilement de couches de nitrure III non recouvertes par lesdites électrodes,
• fixation permanente du substrat à un substrat de support (1), par fixation de la surface de ladite (dudit empilement de) couche(s) isolante(s) (3) audit substrat de support (1),
• retrait du substrat temporaire, en obtenant ainsi une structure ayant une face avant formée par le substrat de support (1), et une face arrière formée par la surface arrière de l'empilement de couches de nitrure III,
• production d'un moyen de liaison desdites électrodes source, de grille et de drain (4, 6, 5) aux bornes externes,
• production d'une plaque électriquement conductrice (12) sur ladite surface arrière de l'empilement de couches de nitrure III, ladite plaque étant reliée électriquement à l'électrode source (4), ladite plaque électriquement conductrice recouvrant au moins une partie de la zone de ladite surface arrière directement en regard d'une zone (20) de ladite surface avant, cette dernière zone (20) étant située entre les électrodes de grille et de drain et directement adjacente à l'électrode de grille
dans lequel ladite plaque électriquement conductrice (12) recouvre une zone de ladite surface arrière qui est directement en regard d'une zone de ladite surface avant, constituée de l'électrode source (4), de la zone entre les électrodes source et de grille (6), de l'électrode de grille (6), et de ladite zone (20) entre les électrodes de grille et de drain et directement adjacente à l'électrode de grille, et dans lequel ladite plaque électriquement conductrice (12) ne recouvre pas la zone correspondant à l'électrode de drain (5),
et dans lequel ladite plaque (12) est en contact direct avec la surface arrière dudit empilement de couches de nitrure III ou dans lequel le procédé comprend une étape de dépôt d'une couche de passivation arrière (11) sur et en contact avec la totalité de la surface arrière de l'empilement de couches de nitrure III et dans lequel ladite plaque (12) est produite sur et en contact avec ladite couche de passivation arrière (11).

5. Procédé selon la revendication 4, dans lequel lesdites électrodes source et de drain (4, 6) sont configurées sous la forme d'électrodes digitiformes adjacentes, s'étendant à partir de plots de source et de drain (14, 15) placés latéralement, ladite électrode de grille étant configurée sous la forme d'une électrode digitiforme reliée à des plots de grille (25) placés latéralement, et dans lequel l'étape de fourniture d'un moyen de liaison desdites électrodes source, de grille et de drain aux bornes externes comprend les étapes de :
• gravure de trous d'interconnexion (17) à travers la face arrière de l'empilement de couches de nitrure III, s'arrêtant sur les plots source, de grille et de drain,
• dépôt sur lesdits trous d'interconnexion d'une couche de métallisation pour relier lesdits plots source, de grille et de drain auxdites bornes externes,
dans lequel une couche de métallisation arrière (18) pour le contact avec le plot source (14) est en outre déposée sur au moins une partie de la surface arrière de l'empilement de couches de nitrure III, pour ainsi former ladite plaque électriquement conductrice.

6. Procédé selon la revendication 5, dans lequel de multiples ensembles d'électrodes source, de grille et de drain (4, 6, 5) sont produits, les électrodes source et de drain étant fournies sous la forme d'électrodes digitiformes s'interpénétrant, s'étendant à partir de plots de source et de drain placés de manière opposée (14, 15).
